# EUROPEAN PATENT APPLICATION

(11) **EP 4 382 221 A1**
(43) Date of publication of application: **12.06.2024**
(21) Application number: 22852129.0
(22) Date of filing: 01.08.2022
(51) Int. Cl.: B08B 9/28, B08B 13/00

(54) **WAFER CASSETTE CLEANING APPARATUS AND CONTROL METHOD THEREFOR**

(30) Priority: 06.08.2021 CN 202110902585
(71) Applicant: Zhonghuan Advanced Semiconductor Technology Co., Ltd., Wuxi, Jiangsu 214203 (CN)
(72) Inventor: XU, Chenge, Xuzhou, Jiangsu 221004 (CN); LI, Yinghui, Xuzhou, Jiangsu 221004 (CN)
(74) Representative: Penza, Giancarlo
(86) International application number: PCT/CN2022/109473
(87) International publication number: WO 2023/011417

(57) **Abstract**

Provided are a method for controlling a wafer cassette cleaning device and a wafer cassette cleaning device. The wafer cassette cleaning device includes a cavity, a rotating frame and a cleaning assembly, wherein a cleaning chamber is arranged in the cavity, the rotating frame is rotatably disposed in the cleaning chamber, the cleaning assembly has a cleaning area and is configured to eject cleaning liquid to the cleaning area, the amount of the cleaning liquid spayed by the cleaning assembly in a first state is greater than the amount of the cleaning liquid spayed by the cleaning assembly in a second state. The control method includes the following steps: the rotating frame driving a wafer cassette to rotate the wafer cassette to rotate relative to the cleaning area, and judging whether the wafer cassette cleaning device satisfies a preset condition, wherein the preset condition is that at least part of the wafer cassette is in the cleaning area; and if it is judged that the wafer cassette cleaning device (100) satisfies the preset condition, switching the cleaning assembly to the first state, and if it is judged that the wafer cassette cleaning device (100) does not satisfy the preset condition, switching the cleaning assembly to the second state.

## Description

### Cross-Reference to Related Application

The present disclosure claims the priority of application 202110902585.6, filed to CNIPA on August 06, 2021, which are incorporated in the present disclosure by reference in its entirety.

### Technical Field

The present disclosure relates to the technical field of wafer cassette cleaning, and in particular to a method for controlling wafer cassette cleaning device and wafer cassette cleaning device.

### Background

In semiconductor production, a wafer cassette mainly plays a role of placing and conveying a wafer (or referred to as a silicon wafer) and directly affects the surface quality of the wafer, therefore in order to ensure the cleanness of an internal environment of the wafer cassette and to avoid contamination of wafers by the wafer cassette, the wafer cassette needs to be cleaned before the wafer is placed therein. However, in related arts, more cleaning liquid needs to be consumed for cleaning the wafer cassette, and the whole cleaning process is time-consuming and low in cleaning efficiency.

### Summary

The present disclosure aims to at least solve one of the technical problems in related arts. Therefore, the present disclosure provides a method for controlling a wafer cassette cleaning device. The method for controlling the wafer cassette cleaning device may reduce the usage amount of cleaning liquid on the premise of ensuring the cleaning effect of a wafer cassette, thereby reducing the cleaning cost.

The present disclosure further provides a wafer cassette cleaning device.

According to the method for controlling the wafer cassette cleaning device in the embodiment of the first aspect of the present disclosure, the wafer cassette cleaning device is configured to clean a wafer cassette, and includes a cavity, a rotating frame and a cleaning assembly, a cleaning chamber is arranged in the cavity, the rotating frame is rotatably disposed in the cleaning chamber and is configured to fix the wafer cassette, the cleaning assembly is disposed in the cavity, the cleaning assembly has a cleaning area and is configured to eject cleaning liquid to the cleaning area, the cleaning assembly has a first state and a second state, and the amount of the cleaning liquid spayed by the cleaning assembly in the first state is greater than the amount of the cleaning liquid ejected by the cleaning assembly in the second state. The method includes: the rotating frame driving the wafer cassette to rotate the wafer cassette relative to the cleaning area, and judging whether the wafer cassette cleaning device satisfies a preset condition, wherein the preset condition includes that at least part of the wafer cassette is in the cleaning area; and if it is judged that the wafer cassette cleaning device (100) satisfies the preset condition, switching the cleaning assembly to the first state, and if it is judged that the wafer cassette cleaning device (100) does not satisfy the preset condition, switching the cleaning assembly to the second state.

According to the control method of the wafer cassette cleaning device in the embodiment of the present disclosure, based on judging whether the wafer cassette cleaning device satisfies the preset condition in the cleaning process of the wafer cassette, and adjusting the state of the cleaning assembly according to a judgement structure, when at least part of the wafer cassette is in the cleaning area, the cleaning assembly cleans the wafer cassette at a relatively large liquid ejection amount, when there is no wafer cassette in the cleaning area, the cleaning assembly uses a relatively small liquid ejection amount, so that the usage amount of the cleaning liquid can be effectively reduced on the premise of ensuring the cleaning effect of the wafer cassette, thereby saving resources and reducing the cleaning cost.

In some embodiments, the cleaning assembly is open in the first state, and the cleaning assembly is closed in the second state; or, the cleaning assembly is open in both the first state and the second state, and a liquid ejection pressure of the cleaning assembly in the first state is greater than a liquid ejection pressure in the second state.

In some embodiments, the rotating frame is suitable for mounting N wafer cassettes, N≥1, N is a positive integer, when N≥2, the N wafer cassettes are disposed at intervals along the circumferential direction of the rotating frame, and with an orthographic projection of a rotation axis of the rotating frame as a circle center on a cross section of the rotating frame, a central angle corresponding to the cleaning area is smaller than a central angle corresponding to an area between two adjacent wafer cassettes.

In some embodiments, the rotating frame has a preset angle position, the wafer cassette cleaning device includes an angle detection structure, the angle detection structure is configured to detect a rotation angle of the rotating frame, when the rotating frame rotates by a first angle from the preset angle position, it is judged that the wafer cassette cleaning device does not satisfy the preset condition, when the rotating frame continues to rotate by a second angle, it is judged that the wafer cassette cleaning device satisfies the preset condition, until the rotating frame continues to rotate by a third angle, it is judged that the wafer cassette cleaning device does not satisfy the preset condition again, wherein on the cross section of the rotating frame, with the orthographic projection of the rotation axis of the rotating frame as the circle center, the sum of the second angle and the third angle is 360°/N.

In some embodiments, the wafer cassette cleaning device includes a detection structure, the detection structure is configured to detect the wafer cassette, a detection direction of the detection structure is the same as an ejection direction of the cleaning assembly, when the detection structure detects the wafer cassette, it is judged that the wafer cassette cleaning device satisfies the preset condition, and when the detection structure does not detect the wafer cassette, it is judged that the wafer cassette cleaning device does not satisfy the preset condition.

In some embodiments, the control method further includes: when the cleaning assembly is switched to the first state, the rotating frame rotating at a rotating speed in a first rotating speed section, and when the cleaning assembly is switched to the second state, the rotating frame rotating at a rotating speed in a second rotating speed section, wherein the minimum rotating speed in the second rotating speed section is greater than the maximum rotating speed in the first rotating speed section.

In some embodiments, when the cleaning assembly is switched to the first state, the rotating frame rotates at a constant speed which is a first rotating speed, when the cleaning assembly is switched to the second state, the rotating frame first accelerates from the first rotating speed to a second rotating speed and then decelerates from the second rotating speed, and the rotating frame decelerates to the first rotating speed until the cleaning assembly is switched to the first state again.

A wafer cassette cleaning device according to an embodiment in a second aspect of the present disclosure includes: a cavity, wherein a cleaning chamber is arranged in the cavity; a rotating frame, wherein the rotating frame is rotatably disposed in the cleaning chamber and is configured to fix a wafer cassette; a cleaning assembly, wherein the cleaning assembly is disposed in the cavity, the cleaning assembly has a cleaning area and is configured to ejection cleaning liquid to the cleaning area, the cleaning assembly has a first state and a second state, and the amount of the cleaning liquid spayed by the cleaning assembly in the first state is greater than the amount of the cleaning liquid ejected by the cleaning assembly in the second state; and an identification assembly, wherein the identification assembly is configured to judge whether the wafer cassette cleaning device satisfies a preset condition when the rotating frame drives the wafer cassette to rotate, when the identification assembly judges that the wafer cassette cleaning device satisfies the preset condition, the cleaning assembly is switched to the first state, when the identification assembly judges that the wafer cassette cleaning device does not satisfy the preset condition, the cleaning assembly is switched to the second state, and the preset condition comprises that at least part of the wafer cassette is in the cleaning area.

According to the wafer cassette cleaning device in the embodiment of the present disclosure, the identification assembly is provided to judge whether the wafer cassette cleaning device satisfies the preset condition, and the cleaning assembly is switched to the corresponding state according to a judgement structure of the identification assembly, therefore when at least part of the wafer cassette is in the cleaning area, the cleaning assembly cleans the wafer cassette at a relatively large liquid ejection amount, when there is no wafer cassette in the cleaning area, the cleaning assembly utilizes a relatively small liquid ejection amount, so that the usage amount of the cleaning liquid can be effectively reduced on the premise of ensuring the cleaning effect of the wafer cassette, thereby saving resources; and moreover, about 1/4 of resources can be saved in the whole cleaning process, thereby reducing the cleaning cost and ensuring the quality of the wafer cassette, thus ensuring the quality of a wafer.

In some embodiments, the cleaning assembly is open in the first state, and the cleaning assembly is closed in the second state; or, the cleaning assembly is open in both the first state and the second state, and a liquid ejection pressure of the cleaning assembly in the first state is greater than a liquid ejection pressure in the second state.

In some embodiments, the rotating frame is suitable for mounting N wafer cassettes, N≥1, N is a positive integer, when N≥2, the N wafer cassettes are disposed at intervals along the circumferential direction of the rotating frame, and with an orthographic projection of a rotation axis of the rotating frame as a circle center on a cross section of the rotating frame, a central angle corresponding to the cleaning area is smaller than a central angle corresponding to an area between two adjacent wafer cassettes, the identification assembly includes an angle detection structure, and the angle detection structure is configured to detect a rotation angle of the rotating frame, and judge, according to the rotation angle of the rotating frame, whether the wafer cassette cleaning device satisfies the preset condition; or, the identification assembly includes a detection structure, the detection direction of the detection structure is the same as the ejection direction of the cleaning assembly, and the detection structure is configured to detect the wafer cassette, and judging, according to whether the wafer cassette is detected, whether the wafer cassette cleaning device satisfies the preset condition.

In some embodiments, the wafer cassette cleaning device further includes: a speed adjustment assembly, the speed adjustment assembly is configured to adjust a rotating speed of the rotating frame, wherein when the cleaning assembly is switched from the first state to the second state, the speed adjustment assembly is configured to increases the rotating speed of the rotating frame firstly, and then reduce the rotating speed of the rotating frame.

Additional aspects and advantages of the present disclosure will be given in part in the following description, and become apparent in part from the following description, or be learned through the practice of the present disclosure.

### Brief Description of the Drawings

The above and/or additional aspects and advantages of the present disclosure will become apparent and readily appreciated from the following description of embodiments in conjunction with the drawings, wherein:
Fig. 1 is a flowchart of a control method of a wafer cassette cleaning device according to one embodiment of the present disclosure;
Fig. 2 is a flowchart of a control method of a wafer cassette cleaning device according to another embodiment of the present disclosure;
Fig. 3 is a flowchart of a control method of a wafer cassette cleaning device according to still another embodiment of the present disclosure;
Fig. 4 is a schematic diagram of a wafer cassette cleaning device according to Embodiment 1 of the present disclosure;
Fig. 5 is another schematic diagram of the wafer cassette cleaning device shown in Fig. 4;
Fig. 6 is a schematic diagram of a cleaning process of the wafer cassette cleaning device shown in Fig. 4;
Fig. 7 is a schematic diagram of a wafer cassette cleaning device according to Embodiment 2 of the present disclosure;
Fig. 8 is a schematic diagram of a wafer cassette cleaning device according to Embodiment 3 of the present disclosure;
Fig. 9 is another schematic diagram of the wafer cassette cleaning device shown in Fig. 8; and
Fig. 10 is a schematic diagram of a wafer cassette cleaning device according to Embodiment 4 of the present disclosure.

### Reference signs:

wafer cassette cleaning device 100, wafer cassette 101, cleaning area R,
cavity 1, cleaning chamber 10,
rotating frame 2, cleaning assembly 3,
identification assembly 4, angle detection structure 41, detection structure 42, and
speed adjustment assembly 5.

### Detailed Description of the Embodiments

Embodiments of the present disclosure are described in detail below, and examples of the embodiments are shown in the drawings, wherein the same or similar reference signs represent the same or similar elements or elements having the same or similar functions all the time. The embodiments described below with reference to the drawings are exemplary, and are merely used to explain the present disclosure, and cannot be understood as limitations to the present disclosure.

The following disclosure provides many different embodiments or examples for implementing different structures of the present disclosure. In order to simplify the disclosure of the present disclosure, components and settings of specific examples are described below. Of course, they are merely examples and are not intended to limit the present disclosure. In addition, the present disclosure may repeat reference numerals and/or letters in different examples. This repetition is for the purpose of simplicity and clarity and does not in itself indicate the relationship between the various embodiments and/or settings discussed. In addition, the present disclosure provides examples of various specific processes and materials, but those ordinary skilled in the art may be aware of the usability of other processes and/or other materials.

Hereinafter, with reference to the drawings, a method for controlling a wafer cassette cleaning device 100 according to an embodiment of the present disclosure is described. The wafer cassette cleaning device 100 is configured to cleaning a wafer cassette 101.

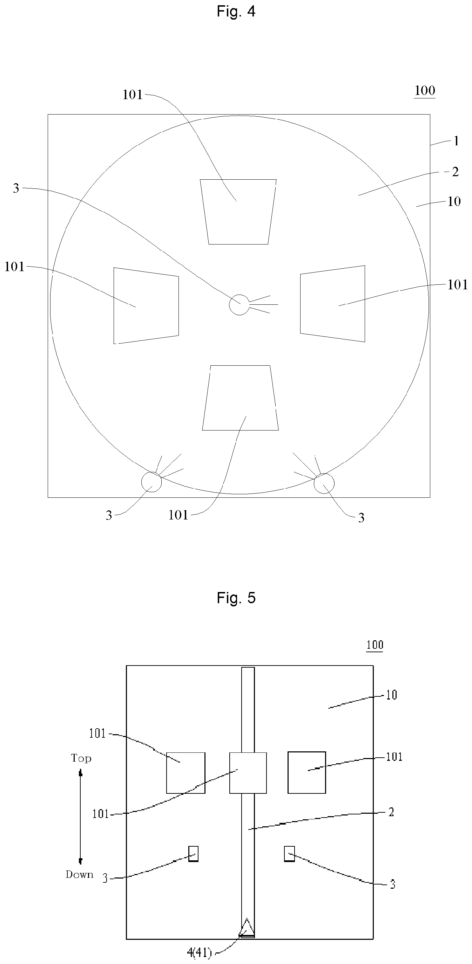

As shown in Fig. 4 and Fig. 5, the wafer cassette cleaning device 100 includes a cavity 1, a rotating frame 2 and a cleaning assembly 3.

A cleaning chamber 10 is arranged in the cavity 1, the rotating frame 2 is rotatably disposed in the cleaning chamber 10, and the rotating frame 2 is configured to fix the wafer cassette 101, so that the wafer cassette 101 can rotate along with the rotating frame 2, thereby conveniently ensuring the comprehensive cleaning of the wafer cassette 101 and facilitating to eliminate "cleaning dead corners". Therefore, the wafer cassette cleaning device 100 can be formed into a rotary wafer cassette cleaning device. For example, one or more wafer cassettes 101 may be fixed on the rotating frame 2, and when a plurality of wafer cassettes 101 are fixed on the rotating frame 2, the wafer cassette cleaning device 100 may simultaneously clean the plurality of wafer cassettes 101, thereby improving the cleaning efficiency.

The cleaning assembly 3 is disposed in the cavity 1, the cleaning assembly 3 has a cleaning area R, and the cleaning assembly 3 is configured to eject cleaning liquid to the cleaning area R, so that the cleaning liquid can effectively clean the wafer cassette 101 in the cleaning area R. The cleaning assembly 3 has a first state and a second state, the cleaning assembly 3 may be switched between the first state and the second state, and the amount of the cleaning liquid spayed by the cleaning assembly 3 in the first state is greater than the amount of the cleaning liquid ejected by the cleaning assembly (3) in the second state.

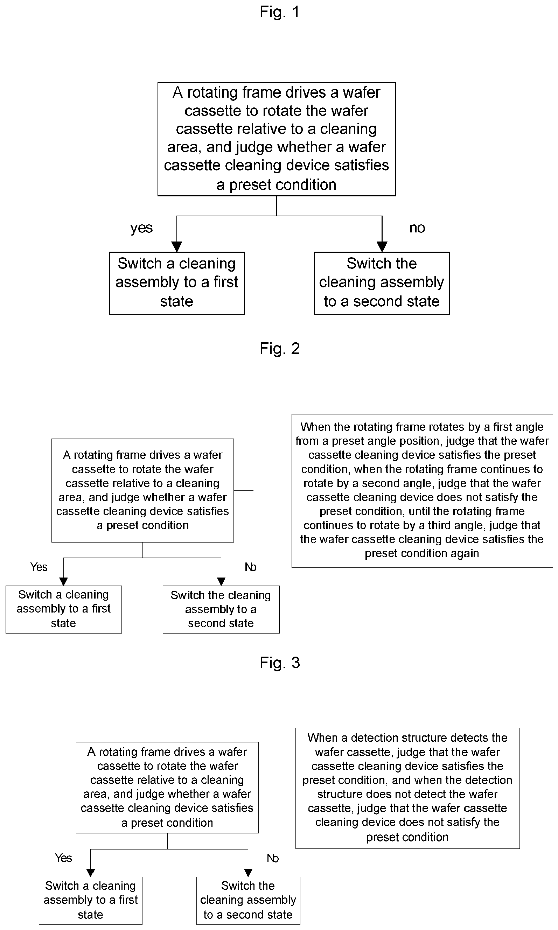

As shown in Fig. 1 to Fig. 3, the method for controlling the wafer cassette cleaning device 100 includes: the rotating frame 2 driving the wafer cassette 101 to rotate the wafer cassette 101 to rotate relative to the cleaning area R, and judging whether the wafer cassette cleaning device 100 satisfies a preset condition; and if it is judged that the wafer cassette cleaning device (100) satisfies the preset condition, switching the cleaning assembly 3 to the first state, and if it is judged that the wafer cassette cleaning device (100) does not satisfy the preset condition, switching the cleaning assembly 3 to the second state, wherein the preset condition includes that at least part of the wafer cassette 101 is in the cleaning area R.

When the wafer cassette cleaning device 100 satisfies the preset condition, the amount of the cleaning liquid spayed by the cleaning assembly 3 is greater than the amount of the cleaning liquid spayed by the cleaning assembly 3 when the wafer cassette cleaning device 100 does not satisfy the preset condition. In other words, when it is judged that at least part of the wafer cassette 101 is in the cleaning area R, the cleaning assembly 3 may effectively clean the wafer cassette 101, and the amount of the cleaning liquid spayed by the cleaning assembly 3 is "a"; when it is judged that there is no wafer cassette 101 is in the cleaning area R, the cleaning assembly 3 cannot effectively clean the wafer cassette 101, the amount of the cleaning liquid spayed by the cleaning assembly 3 is "b", and b<a, therefore on the premise of ensuring the cleaning effect of the wafer cassette 101, the amount of the cleaning liquid used in the whole cleaning process can be reduced, thereby saving resources, and reducing the cleaning cost of the wafer cassette 101, for example, when the cleaning liquid is water, water resources can be saved.

The amount of ejected liquid may be understood as the amount of fluid ejected by the cleaning assembly 3 to the cleaning area R in unit time, and when at least part of the wafer cassette 101 is in the cleaning area R, the amount of fluid ejected by the cleaning assembly 3 to the cleaning area R is greater than the amount of fluid ejected by the cleaning assembly 3 to the cleaning area R when there is no wafer cassette 101 in the cleaning area R.

It should be noted that, in the description of the present disclosure, the "cleaning liquid" should be broadly understood, for example, the cleaning liquid may be water, or steam, or a mixed solution of water and steam, or a cleaning agent, and the like, as long as it is ensured that the cleaning liquid may clean the wafer cassette 101 to remove dirt from the wafer cassette 101. For example, the cleaning liquid may be ultrapure water (also referred to as UP water, which refers to water having a resistivity of 18M Ω*cm(25°C).

Therefore, compared with some arts, in the whole cleaning process of the wafer cassette, the rotating frame rotates at a constant speed all the time, and the cleaning assembly always keeps a certain amount of ejected liquid, that is, in the rotation process of the rotating frame, the amount of the cleaning liquid spayed by the cleaning assembly remains unchanged, resulting in relatively high usage amount of the cleaning liquid. According to the method for controlling the wafer cassette cleaning device 100 of the present disclosure, by judging whether the wafer cassette cleaning device 100 satisfies the preset condition in the cleaning process of the wafer cassette 101, and adjusting the state of the cleaning assembly 3 according to a judgement structure, when at least part of the wafer cassette 100 is in the cleaning area R, the cleaning assembly 3 cleans the wafer cassette 101 at a relatively large amount of ejected amount, when there is no wafer cassette 101 in the cleaning area R, the cleaning assembly 3 utilizes a relatively small amount of ejected amount, so that the usage amount of cleaning liquid can be effectively reduced to save resources on the premise of ensuring the cleaning effect of the wafer cassette 101; and moreover, about 1/4 of resources can be saved in the whole cleaning process, thereby reducing the cleaning cost and ensuring the quality of the wafer cassette 101, thus ensuring the quality of a wafer.

For example, there may be one or more cleaning assemblies 3; and the cleaning areas R of a plurality of cleaning assemblies 3 may be the same or different, and the cleaning liquid used by the plurality of cleaning assemblies 3 may be the same or different.

It can be understood that, when there are a plurality of cleaning assemblies 3 and the cleaning areas R of the plurality of cleaning assemblies 3 are different, comprehensive cleaning of the wafer cassette 101 is facilitated, and the cleaning effect is ensured.

In some embodiments, the cleaning assembly 3 is open in the first state, the amount of the cleaning liquid spayed by the cleaning assembly 3 is greater than zero at this time, the cleaning assembly 3 is closed in the second state, and the amount of the cleaning liquid spayed by the cleaning assembly 3 is zero at this time, thereby conveniently ensuring that the amount of the cleaning liquid spayed by the cleaning assembly 3 in the first state is greater than the amount of the cleaning liquid ejected by the cleaning assembly (3) in the second state; at this time, when it is judged that the wafer cassette cleaning device 100 satisfies the preset condition, the cleaning assembly 3 is open, thereby ensuring that the cleaning assembly 3 effectively cleans the wafer cassette 101, and thus realizing the cleaning of the wafer cassette 101; and when it is judged that the wafer cassette cleaning device 100 does not satisfy the preset condition, the cleaning assembly 3 is closed, so as to further reduce the usage amount of the cleaning liquid in the cleaning process.

Of course, the present disclosure is not limited thereto. In some other embodiments, the cleaning assembly 3 is open in both the first state and the second state, the liquid ejection amounts of the cleaning assembly 3 in the first state and the second state are both greater than zero, and the liquid ejection pressure of the cleaning assembly 3 in the first state is greater than the liquid ejection pressure in the second state, therefore it can also be ensured that the amount of the cleaning liquid spayed by the cleaning assembly 3 in the first state is greater than the amount of the cleaning liquid ejected by the cleaning assembly (3) in the second state; at this time, when it is judged that the wafer cassette cleaning device 100 satisfies the preset condition, the cleaning assembly 3 ejects the cleaning liquid at a first pressure, so as to ensure that the cleaning assembly 3 effectively cleans the wafer cassette 101; and when it is judged that the wafer cassette cleaning device 100 does not satisfy the preset condition, the cleaning assembly 3 ejects the cleaning liquid at a second pressure, the second pressure is smaller than the first pressure, for example, the first pressure is a high pressure, and the second pressure is a normal pressure, therefore it is ensured that the cleaning liquid effectively removes dirt on the surface of the wafer cassette 101, which is beneficial to improving the cleaning effect of the wafer cassette 101 by the cleaning assembly 3, the usage amount of the cleaning liquid in the cleaning process can also be reduced, and the cleaning time can be shortened to a certain extent, thereby improving the cleaning efficiency.

In some embodiments, as shown in Fig. 1 to Fig. 2, the rotating frame 2 is adapted to mount N number of the wafer cassettes 101, N is larger than or equal to 1, and N is a positive integer, therefore one or more wafer cassettes 101 may be installed on the rotating frame 2. When N is larger than or equal to 2, the N number of the wafer cassettes 101 are arranged at intervals in the circumferential direction of the rotating frame 2, with an orthographic projection of a rotation axis of the rotating frame 2 as a circle center on a cross section of the rotating frame 2, a central angle corresponding to the cleaning area R is smaller than a central angle corresponding to an area between two adjacent wafer cassettes 101, therefore when the rotating frame 2 drives the N wafer cassettes 101 to rotate, there is absolutely a case in which all wafer cassettes 101 are not in the cleaning area R, at this time, the cleaning assembly 3 is switched to the second state to save water, and moreover, the N wafer cassettes 101 may sequentially and circularly pass through the cleaning area R, so as to realize the simultaneous cleaning of the N wafer cassettes 101.

In addition, since the central angle corresponding to the cleaning area R is smaller than the central angle corresponding to the area between two adjacent wafer cassettes 101, the arrangement requirements, the number requirements and the like for the cleaning assembly 3 can be reduced, so that the cleaning assembly 3 can conveniently satisfy the setting of the cleaning area R. The circumferential direction of the rotating frame 2 is a direction around the rotation axis of the rotating frame 2, and the circumferential direction of the rotating frame 2 is perpendicular to the axial direction of the rotating frame 2.

It can be understood that, on the cross section of the rotating frame 2, with the orthographic projection of the rotation axis of the rotating frame 2 as the circle center, the central angle corresponding to the cleaning area R may be less than, or equal to, or greater than the central angle corresponding to the wafer cassette 101.

For example, on the cross section of the rotating frame 2, with the orthographic projection of the rotation axis of the rotating frame 2 as the circle center, the central angle corresponding to the cleaning area R is smaller than or equal to the central angle corresponding to the wafer cassette 101, at this time, the cleaning area R is relatively small, thereby facilitating to reduce the number of the cleaning assemblies 3, and facilitating to reduce the arrangement requirements of the cleaning assembly 3.

In some embodiments, as shown in Fig. 2, Fig. 5 and Fig. 7, the rotating frame 2 has a preset angle position, the wafer cassette cleaning device 100 includes an angle detection structure 41, the angle detection structure 41 is configured to measure a rotation angle of the rotating frame 2, and the angle detection structure 41 is configured to judge, according to the rotation angle of the rotating frame 2, whether the wafer cassette cleaning device 100 satisfies the preset condition.

Specifically, when the rotating frame 2 rotates by a first angle α from the preset angle position, it is judged that the wafer cassette cleaning device 100 satisfies the preset condition, when the rotating frame 2 continues to rotate by a second angle β, at this time, the rotating frame 2 rotates by an angle of α+β relative to the preset angle position, then it is judged that the wafer cassette cleaning device 100 does not satisfy the preset condition, until the rotating frame 2 continues to rotate by a third angle γ, it is judged that the wafer cassette cleaning device 100 satisfies the preset condition again, wherein on the cross section of the rotating frame 2, with the orthographic projection of the rotation axis of the rotating frame 2 as the circle center, the sum of the second angle β and the third angle γ is 360°/N, then when N=1 ,"the rotating frame 2 continuing to rotate by the third angle γ" in the above process indicates that the wafer cassette 101 is rotated into the cleaning area R again, when N is larger than or equal to 2, "the rotating frame 2 continuing to rotate by the third angle γ " in the above process indicates that the next wafer cassette 101 is rotated into the cleaning area R, until the rotating frame 2 rotates by 360° from the preset angle position, and then the next cleaning circulation process is performed.

It can be understood that, the first angle α may satisfy α≥0°, and the first angle α may be specifically set according to the cleaning area R, the placement position of the wafer cassette 100, etc.

On the cross section of the rotating frame 2, with a orthographic projection of the rotation axis of the rotating frame 2 as the circle center, the sum of the second angle β and the third angle γ is 360°/N, then when N is1,"the rotating frame 2 continuing to rotate by the third angle γ " in the above process indicates that the wafer cassette 101 is rotated into the cleaning area R again, when N is larger than or equal to 2, "the rotating frame 2 continuing to rotate by the third angle γ" in the above process indicates that the next wafer cassette 101 is rotated into the cleaning area R, until the rotating frame 2 rotates by 360° from the preset angle position, and then the next circulation is performed.

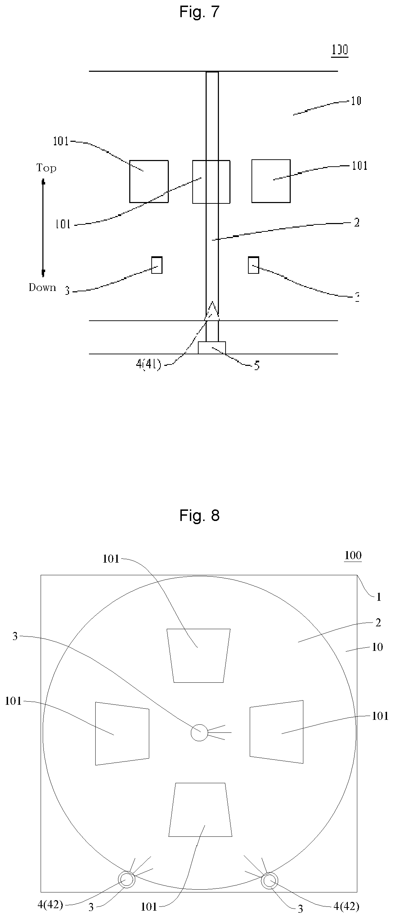

For example, in the example of Fig. 5 and Fig. 7, the angle detection structure 41 may be disposed on the rotating frame 2, for example, the angle detection structure 41 is disposed at the rotation axis position of the rotating frame 2, or the cavity 1 is provided with a rotating shaft, the rotating shaft drives the rotating frame 2 to rotate, and the angle detection structure 41 is disposed on the rotating shaft; the cleaning assembly 3 includes a first cleaning assembly and a second cleaning assembly, the first cleaning assembly and the second cleaning assembly are disposed at intervals in the circumferential direction of the rotating frame 2, and the first cleaning assembly and the second cleaning assembly are both disposed on a wall surface of the cleaning chamber 10, and the cleaning area R may be formed when the first cleaning assembly and the second cleaning assembly eject the cleaning liquid; and a side wall of the cleaning chamber 10 is provided with an opening, the opening is provided with an opening and closing door to open or close the opening, four wafer cassettes 101 may be installed on the rotating frame 2, and the four wafer cassettes 101 may be uniformly disposed at intervals along the circumferential direction of the rotating frame 2.

Hereinafter, it is taken as an example to describe the cleaning process of the wafer cassette 101 that, at the preset angle position, one wafer cassette 101 may be disposed to align with the opening and closing door in a radial direction of the rotating frame 2, and those skilled in the art would easily understand that the preset angle position is the cleaning process of other states. The N wafer cassettes 101 are uniformly disposed in a circumferential direction of the rotating frame 2, and the cleaning process of the wafer cassettes 101 is as follows:
(1) when the rotating frame 2 rotates by the first angle α from the preset angle position (rotating counterclockwise or clockwise), it is judged that the wafer cassette cleaning device 100 does not satisfy the preset condition, the Nth wafer cassette 101 completely leaves the cleaning area R, the first cleaning assembly and the second cleaning assembly are both switched to the second state, the rotating frame 2 continues to rotate by the second angle β, at this time, the rotating frame 2 rotates by an angle of α+β relative to the preset angle position, the first wafer cassette 101 starts to enter the cleaning area R, it is judged that the wafer cassette cleaning device 100 satisfies the preset condition, and the first cleaning assembly and the second cleaning assembly are both switched to the first state, so as to clean the first wafer cassette 101, until the rotating frame 2 continues to rotate by the third angle γ, at this time, the rotating frame 2 rotates by an angle of α+β+γ relative to the preset angle position, the first wafer cassette 101 completely leaves the cleaning area R, it is judged that the wafer cassette cleaning device 100 does not satisfy the preset condition again, and the first cleaning assembly and the second cleaning assembly are both switched to the second state.
(2) The rotating frame 2 continues to rotate by the second angle β, at this time, the rotating frame 2 rotates by an angle of α+2*β+γ relative to the preset angle position, the second wafer cassette 101 starts to enter the cleaning area R, it is judged that the wafer cassette cleaning device 100 satisfies the preset condition again, and the first cleaning assembly and the second cleaning assembly are both switched to the first state, so as to clean the second wafer cassette 101, until the rotating frame 2 continues to rotate by the third angle γ, at this time, the rotating frame 2 rotates by an angle of α+2*β+2*γ relative to the preset angle position, the second wafer cassette 101 completely leaves the cleaning area R, it is judged that the wafer cassette cleaning device 100 does not satisfy the preset condition again, and the first cleaning assembly and the second cleaning assembly are both switched to the second state.
(3) The rotating frame 2 continues to rotate by the second angle β, at this time, the rotating frame 2 rotates by an angle of α+3*β+2*γ relative to the preset angle position, the third wafer cassette 101 starts to enter the cleaning area R, it is judged that the wafer cassette cleaning device 100 satisfies the preset condition again, and the first cleaning assembly and the second cleaning assembly are both switched to the first state, so as to clean the third wafer cassette 101, until the rotating frame 2 continues to rotate by the third angle γ, at this time, the rotating frame 2 rotates by an angle of α+3*β+3*γ relative to the preset angle position, the third wafer cassette 101 completely leaves the cleaning area R, it is judged that the wafer cassette cleaning device 100 does not satisfy the preset condition again, and the first cleaning assembly and the second cleaning assembly are both switched to the second state.
(4) The rotating frame 2 continues to rotate to sequentially clean the fourth ... the Nth wafer cassette 101, until the rotating frame 2 rotates by 360° relative to the preset angle position, and then the next circulation is performed to sequentially perform (1) to (4).

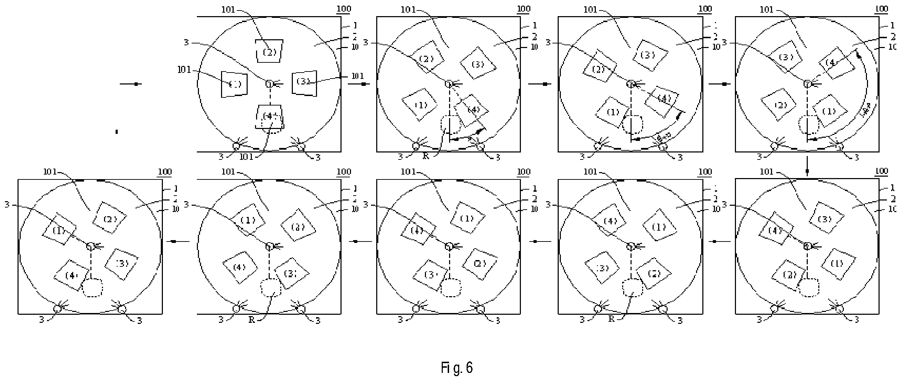

For example, in the example of Fig. 6, four wafer cassettes 101 are disposed on the rotating frame 2, the four wafer cassettes 101 are uniformly disposed in the circumferential direction of the rotating frame 2 and are numbered sequentially, and at the preset angle position, the fourth wafer cassette 101 may be disposed to align with the opening and closing door in the radial direction of the rotating frame 2, and the cleaning process of the wafer cassettes 101 is as follows:
(1) When the rotating frame 2 rotates counterclockwise by the first angle of α=36.25° from the preset angle position, it is judged that the wafer cassette cleaning device 100 does not satisfy the preset condition, the fourth wafer cassette 101 completely leaves the cleaning area R, the first cleaning assembly and the second cleaning assembly are both switched to the second state, the rotating frame 2 continues to rotate by the second angle β=22.5°, at this time, the rotating frame 2 rotates by an angle of α+β=58.75° relative to the preset angle position, the first wafer cassette 101 starts to enter the cleaning area R, it is judged that the wafer cassette cleaning device 100 satisfies the preset condition, the first cleaning assembly and the second cleaning assembly are both switched to the first state, so as to clean the first wafer cassette 101, until the rotating frame 2 continues to rotate by the third angle γ=67.5°, at this time, the rotating frame 2 rotates by an angle of α+β+γ=126.25° relative to the preset angle position, the first wafer cassette 101 completely leaves the cleaning area R, it is judged that the wafer cassette cleaning device 100 does not satisfy the preset condition again, and the first cleaning assembly and the second cleaning assembly are both switched to the second state.
(2) The rotating frame 2 continues to rotate by the second angle β=22.5°, at this time, the rotating frame 2 rotates by an angle of α+2*β+γ=148.75° relative to the preset angle position, the second wafer cassette 101 starts to enter the cleaning area R, it is judged that the wafer cassette cleaning device 100 satisfies the preset condition again, and the first cleaning assembly and the second cleaning assembly are both switched to the first state, so as to clean the second wafer cassette 101, until the rotating frame 2 continues to rotate by the third angle γ=67.5°, at this time, the rotating frame 2 rotates by an angle of α+2*β+2*γ=216.25° relative to the preset angle position, the second wafer cassette 101 completely leaves the cleaning area R, it is judged that the wafer cassette cleaning device 100 does not satisfy the preset condition again, and the first cleaning assembly and the second cleaning assembly are both switched to the second state.
(3) The rotating frame 2 continues to rotate by the second angle β=22.5°, at this time, the rotating frame 2 rotates by an angle of α+3*β+2*γ=238.75° relative to the preset angle position, the third wafer cassette 101 starts to enter the cleaning area R, it is judged that the wafer cassette cleaning device 100 satisfies the preset condition again, and the first cleaning assembly and the second cleaning assembly are both switched to the first state, so as to clean the third wafer cassette 101, until the rotating frame 2 continues to rotate by the third angle γ=67.5°, at this time, the rotating frame 2 rotates by an angle of α+3*β+3*γ=306.25° relative to the preset angle position, the third wafer cassette 101 completely leaves the cleaning area R, it is judged that the wafer cassette cleaning device 100 does not satisfy the preset condition again, and the first cleaning assembly and the second cleaning assembly are both switched to the second state.
(4) The rotating frame 2 continues to rotate by the second angle β=22.5°, at this time, the rotating frame 2 rotates by an angle of α+4*β+3*γ=328.75° relative to the preset angle position, the fourth wafer cassette 101 starts to enter the cleaning area R, it is judged that the wafer cassette cleaning device 100 satisfies the preset condition again, and the first cleaning assembly and the second cleaning assembly are both switched to the first state, so as to clean the fourth wafer cassette 101, until the rotating frame 2 continues to rotate by 360° relative to the preset angle position, and then the next circulation is performed to sequentially perform (1) to (4).

In this way, if the cleaning assembly 3 is closed in the second state, the cleaning liquid is not consumed at this time, when the rotating frame 2 rotates by one circle and the cleaning assembly 3 is in the turned-off state by means of the above steps, the sum of the rotation angles of the rotating frame 2 should be: (58.75°-36.25°) + (148.75°-126.25°) + (238.75°-216.25°) + (328.75°-306.25°) =90°, that is, during the process of the rotating frame 2 rotating by one circle, when the cleaning assembly 3 is in the closed state, the rotation angle of the rotating frame 2 accounts for 1/4 of the corresponding angle when the rotating frame 2 rotates by one circle; then, if the rotating frame 2 rotates at a constant speed in the rotation process, and the cleaning assembly 3 keeps a constant liquid ejection amount in the first state, when the rotating frame 2 rotates by one circle, compared with the solution in which the cleaning assembly is open all the time, the above solution of the present disclosure may save 1/4 cleaning liquid, for example, when the cleaning liquid is water, 25% of water can be saved.

For example, it is calculated such that the water is configured to clean each group of wafer cassettes by 20 minutes, and 30L water is consumed per minute, the cleaning assembly is open all the time, then the amount of water configured to clean each group of wafer cassettes is about 20*30=600L; and the amount of water used in the above solution of the present disclosure is 600*0.25=150L. If 20 groups of wafer cassettes are cleaned every day, the amount of water saved by each wafer cassette cleaning device 100 every day is about 150L*20=3 tons, and then about 90 tons of water may be saved every month.

Of course, the cleaning assembly 3 may further include a third cleaning assembly, the third cleaning assembly is disposed at the rotation axis of the rotating frame 2, and the third cleaning assembly may substantially eject the cleaning liquid outwards in the radial direction of the rotating frame 2. When the first cleaning assembly and the second cleaning assembly are both switched to the first state, the third cleaning assembly is also switched to the first state, and when the first cleaning assembly and the second cleaning assembly are both switched to the second state, the third cleaning assembly is also switched to the second state; and of course, the switching logic of the third cleaning assembly is not limited thereto.

In some embodiments, as shown in Fig. 3 and Fig. 8 to Fig. 10, the wafer cassette cleaning device 100 includes a detection structure 42, the detection direction of the detection structure 42 is the same as the ejection direction of the cleaning assembly 3, the detection structure 42 is configured to detect the wafer cassette 101, and the detection structure 42 is configured to judge, according to whether the wafer cassette 101 is detected, whether the wafer cassette cleaning device 100 satisfies the preset condition. Specifically, when the detection structure 42 detects the wafer cassette 101, it indicates that at least part of the wafer cassette 101 is in the cleaning area R, then it is judged that the wafer cassette cleaning device 100 satisfies the preset condition, so that the cleaning assembly 3 is switched to the first state; and when the detection structure 42 does not detect the wafer cassette 101, it indicates that the wafer cassette 101 is not in the cleaning area R, then it is judged that the wafer cassette cleaning device 100 does not satisfy the preset condition, so that the cleaning assembly 3 is switched to the second state.

In some embodiments, in the example of Fig. 8 to Fig. 10, the detection structure 42 may be disposed at a nozzle of the cleaning assembly 3, when the detection structure 42 detects the wafer cassette 101, it indicates that the wafer cassette 101 shields a detection signal of the detection structure 42, then the wafer cassette 101 is located on an ejection path of the cleaning assembly 3, so that at least part of the wafer cassette 101 is in the cleaning area R; and when the detection structure 42 does not detect the wafer cassette 101, it indicates that the wafer cassette 101 does not shield the detection signal of the detection structure 42, then the wafer cassette 101 is not located on the ejection path of the cleaning assembly 3, so that the wafer cassette 101 is not in the cleaning area R.

For example, the detection structure 42 may be an infrared device, and the infrared device may detect the wafer cassette 101 through an infrared signal.

In some embodiments, the method further includes: when the cleaning assembly 3 is switched to the first state, the rotating frame 2 rotating at a rotating speed in a first rotating speed section, and when the cleaning assembly 3 is switched to the second state, the rotating frame 2 rotating at a rotating speed in a second rotating speed section, wherein the minimum rotating speed in the second rotating speed section is greater than the maximum rotating speed in the first rotating speed section, therefore when there is no wafer cassette 101 in the cleaning area R, the cleaning assembly 3 cannot effectively clean the wafer cassette 101, the rotating speed of the rotating frame 2 is set to be greater in this process, so that the rotating frame 2 quickly passes through a "neutral period", thereby shortening the time when the wafer cassette 101 is not effectively cleaned, which facilitates to shorten the cleaning duration and improve the cleaning efficiency, thus improving the yield of the wafer cassette cleaning device 100.

It can be understood that, when the cleaning assembly 3 is switched to the first state, the rotating frame 2 may rotate at a constant speed or at a variable speed in the first rotating speed section, and when the cleaning assembly 3 is switched to the second state, the rotating frame 2 may rotate at a constant speed or at a variable speed in the second rotating speed section.

In some embodiments, when the cleaning assembly 3 is switched to the first state, the rotating frame 2 rotates at a constant speed of first rotating speed, so as to ensure the overall cleaning effect of the wafer cassette 101; and when the cleaning assembly 3 is switched to the second state, the rotating frame 2 first accelerates from the first rotating speed to a second rotating speed and then decelerates from the second rotating speed until the cleaning assembly 3 is switched to the first state again, and the rotating frame 2 decelerates to the first rotating speed, so that when the cleaning assembly 3 is switched between the first state and the second state, the adjustment of the rotating speed of the rotating frame 2 has good coherence.

It can be understood that, in the whole process of keeping the cleaning assembly 3 in the second state, the rotation process of the rotating frame 2 may include an acceleration stage and a deceleration stage, the rotating frame 2 accelerates from the first rotating speed to the second rotating speed in the acceleration stage, the rotating frame 2 decelerates from the second rotating speed to the first rotating speed in the deceleration stage, and an absolute value of the acceleration in the acceleration stage and an absolute value of the acceleration in the deceleration stage may be equal or unequal, the present disclosure is not limited thereto. For example, in the whole process of keeping the cleaning assembly 3 in the second state, in addition to the acceleration stage and the deceleration stage, the rotation process of the rotating frame 2 may further include a constant speed stage, and the rotating frame 2 rotates at a constant speed of the second rotating speed in the constant speed stage.

When there is no wafer cassette 101 in the cleaning area R, the rotating speed of the rotating frame 2 is set to be larger, so that the rotating frame 2 quickly passes through the "neutral period", and by means of reasonably setting the rotating speed of the rotating frame 2, the rotation time of the rotating frame 2 passing through the "neutral period" may be saved by about 50%; and when the angle corresponding to the "neutral period" occupies 1/4 of the whole circle angle, when the rotating frame 2 rotates by one circle, about 25%*50%=12.5% of rotation time may be saved, that is, when the rotating frame 2 rotates by one circle, the present disclosure may save about 12.5% of time compared with the solution of rotating at a constant speed. For example, in the related art, the rotating frame always rotates at a constant speed, 20 minutes is required to achieve an expected cleaning effect, then the same cleaning effect can be achieved only by 17.5 minutes in the present disclosure, thereby shortening the cleaning time of the "neutral period", and effectively improving the cleaning efficiency.

A first cleaning solution used in some arts is compared with the solution in the present disclosure (hereinafter referred to as a "second cleaning solution". The first cleaning solution is: the cleaning duration is 18min, 5 turns are rotated per minute, and the cleaning assembly always ejects the cleaning liquid, then the total number of rotation turns of the rotating frame in the cleaning process is 90 turns; the second cleaning solution is: the cleaning assembly 3 is closed in the "neutral period", the rotating frame 2 quickly passes through the "neutral period", so that the cleaning duration can be saved by about 12.5%, and the total number of rotation turns of the rotating frame 2 is 18*5/(1-0.125)≈103 round under the same cleaning duration of 18min.

After the cleaning is completed, clean water, such as ultrapure water, is injected into the wafer cassette, water injection is stopped after reaching an expected water amount, the wafer cassette is oscillated to enable the clean water to fully touch the inner wall of the wafer cassette, so that particles in the wafer cassette are dissolved into water to form liquid to be tested, stewing is performed after a period of time, after the stewing is completed, the liquid to be tested is extracted by using a laser particle calculator (LPC), and the particle condition in the liquid to be tested, that is, the number of particles in the water, is measured, so as to reflect the cleanliness of cleaning the wafer cassette. The measurement results are shown in the following table:

| LPC | 0.2um(ea/ml) | 0.5um(ea/ml) |
|---|---|---|
| First cleaning solution | 12.5 | 1.4 |
| | 16.6 | 1.9 |
| | 13.6 | 1.6 |
| | 10.7 | 1.3 |
| Second cleaning solution | 9.7 | 1.3 |
| | 8.4 | 1.1 |
| | 5 | 0.9 |
| | 7.6 | 1 |

The LPC (Laser Particle Counter) in the above table is a particle counter, which detects, in a detection mode of a light scattering method, the size and number of particles contained in the liquid flowing through the interior of a machine table, that is, liquid particle concentration, for example, 0.5µm (ea/mL) means the number of particles having a particle diameter greater than 0.5µm in each milliliter of solution. Obviously, within the same cleaning time, the rotation period of the second cleaning solution is longer, that is, the rotation time of the wafer cassette in the effective cleaning area R is prolonged, the rotation time of the wafer cassette in an invalid cleaning area R is shortened, and compared with the first cleaning solution, the particle content (or non-metal content) is obviously reduced, such that a relatively good cleaning effect can be achieved.

Compared with the first cleaning solution in the above table, the second cleaning solution has relatively lower concentration of particles of 0.2um & 0.5um or more, that is, the cleanliness of the interior of the wafer cassette cleaned by using the second cleaning solution is better, and thus the cleaning effect is good. For example, for the wafer cassette cleaned by using the first cleaning solution, the average concentration of particles of 0.2um or more is 13.35ea/mL, and the average concentration of particles of 0.5um or more is 1.55ea/mL; and for the wafer cassette cleaned by using the second cleaning solution, the average concentration of particles of 0.2um or more is 7.675ea/mL, and the average concentration of particles of 0.5um or more is 1.075ea/mL.

A wafer cassette cleaning device 100 according to an embodiment in a second aspect of the present disclosure includes: a cavity 1, a rotating frame 2, a cleaning assembly 3 and an identification assembly 4.

As shown in Fig. 4 and Fig. 5, a cleaning chamber 10 is arranged in the cavity 1; the rotating frame 2 is rotatably disposed in the cleaning chamber 10, and the rotating frame 2 is configured to fix a wafer cassette 101, and then the wafer cassette 101 may rotate around a rotation axis of the rotating frame 2 along with the rotating frame 2, for example, in the example of Fig. 5, the rotation axis of the rotating frame 2 extends vertically in an upper-lower direction. The cleaning assembly 3 is disposed in the cavity 1, the cleaning assembly 3 has a cleaning area R, the cleaning assembly 3 is configured to eject cleaning liquid to the cleaning area R, and the cleaning liquid may effectively clean the wafer cassette 101 in the cleaning area R. The cleaning assembly 3 has a first state and a second state, and the amount of the cleaning liquid spayed by the cleaning assembly 3 in the first state is greater than the amount of the cleaning liquid ejected by the cleaning assembly in the second state.

The identification assembly 4 is configured to judge whether the wafer cassette cleaning device 100 satisfies a preset condition when the rotating frame 2 drives the wafer cassette 101 to rotate, when the identification assembly 4 judges that the wafer cassette cleaning device 100 satisfies the preset condition, the cleaning assembly 3 is switched to the first state, so as to ensure the cleaning effect of the wafer cassette 101 by the cleaning assembly 3; and when the identification assembly 4 judges that the wafer cassette cleaning device 100 does not satisfy the preset condition, the cleaning assembly 3 is switched to the second state, so as to reduce the usage amount of the cleaning liquid in the cleaning process of the wafer cassette 101, wherein the preset condition includes that at least part of the wafer cassette 101 is in the cleaning area R.

Therefore, according to the wafer cassette cleaning device 100 in the embodiment of the present disclosure, the identification assembly 4 is provided to judge whether the wafer cassette cleaning device 100 satisfies the preset condition, and the cleaning assembly 3 is switched to the corresponding state according to a judgment structure of the identification assembly 4, therefore when at least part of the wafer cassette 101 is in the cleaning area R, the cleaning assembly 3 cleans the wafer cassette 101 at a relatively large liquid ejection amount, when there is no wafer cassette 101 in the cleaning area R, the cleaning assembly 3 utilizes a relatively small liquid ejection amount, so that the usage amount of the cleaning liquid can be effectively reduced on the premise of ensuring the cleaning effect of the wafer cassette 101, thereby saving resources; and moreover, about 1/4 of resources can be saved in the entire cleaning process, thereby reducing the cleaning cost and ensuring the quality of the wafer cassette 101, thus ensuring the quality of a wafer.

In some embodiments, the cleaning assembly 3 is open in the first state, and the cleaning assembly 3 is closed in the second state, so as to ensure that the amount of the cleaning liquid spayed by the cleaning assembly 3 in the first state is greater than the amount of the cleaning liquid ejected by the cleaning assembly in the second state.

In some other embodiments, the cleaning assembly 3 is open in both the first state and the second state, and the liquid ejection pressure of the cleaning assembly 3 in the first state is greater than the liquid ejection pressure in the second state, and it can also be ensured that the amount of the cleaning liquid spayed by the cleaning assembly 3 in the first state is greater than the amount of the cleaning liquid ejected by the cleaning assembly in the second state.

In some embodiments, as shown in Fig. 4 and Fig. 5, the rotating frame 2 is suitable for mounting N wafer cassettes 101, N is larger than or equal to 1, and N is a positive integer. When N is larger than or equal to 2, the N wafer cassettes 101 are disposed at intervals in the circumferential direction of the rotating frame 2, and on a cross section of the rotating frame 2, with an orthographic projection of a rotation axis of the rotating frame 2 as a circle center, a central angle corresponding to the cleaning area R is smaller than a central angle corresponding to an area between two adjacent wafer cassettes 101, therefore when the rotating frame 2 drives the N wafer cassettes 101 to rotate, there is absolutely a case in which all wafer cassettes 101 are not in the cleaning area R, at this time, the cleaning assembly 3 is switched to the second state to save water, and moreover, the N wafer cassettes 101 may sequentially and circularly pass through the cleaning area R, so as to realize the simultaneous cleaning of the N wafer cassettes 101.

Furthermore, since the central angle corresponding to the cleaning area R is smaller than the central angle corresponding to the area between two adjacent wafer cassettes 101, the arrangement requirements, the number requirements and the like for the cleaning assembly 3 can be reduced, so that the cleaning assembly 3 can conveniently satisfy the setting of the cleaning area R. The circumferential direction of the rotating frame 2 is a direction around the rotation axis of the rotating frame 2, and the circumferential direction of the rotating frame 2 is perpendicular to the axial direction of the rotating frame 2.

In some embodiments, as shown in Fig. 2, Fig. 5 and Fig. 7, the identification assembly 4 includes an angle detection structure 41, the angle detection structure 41 is configured to detect a rotation angle of the rotating frame 2, and the angle detection structure 41 is configured to judge, according to the rotation angle of the rotating frame 2, whether the wafer cassette cleaning device 100 satisfies the preset condition. For example, the rotating frame 2 has a preset angle position, and the angle detection structure 41 may detect an angle by which the rotating frame 2 rotates from the preset angle position to the current angle position.

Specifically, when the rotating frame 2 rotates by a first angle α from the preset angle position, it is judged that the wafer cassette cleaning device 100 does not satisfy the preset condition, the rotating frame 2 continues to rotate by a second angle β, at this time, the rotating frame 2 rotates by an angle of α+β relative to the preset angle position, then it is judged that the wafer cassette cleaning device 100 satisfies the preset condition, until the rotating frame 2 continues to rotate by a third angle γ, it is judged that the wafer cassette cleaning device 100 does not satisfy the preset condition again, wherein on the cross section of the rotating frame 2, with the orthographic projection of the rotation axis of the rotating frame 2 as the circle center, the sum of the second angle β and the third angle γ is 360°/N.

Of course, the setting of the identification assembly 4 in the present disclosure is not limited thereto. In some embodiments, as shown in Fig. 3 and Fig. 8 to Fig. 10, the identification assembly 4 includes a detection structure 42, the detection direction of the detection structure 42 is the same as the ejection direction of the cleaning assembly 3, the detection structure 42 is configured to detect the wafer cassette 101, and the detection structure 42 is configured to judge, according to whether the wafer cassette 101 is detected, whether the wafer cassette cleaning device 100 satisfies the preset condition.

For example, when the detection structure 42 detects the wafer cassette 101, it indicates that at least part of the wafer cassette 101 is in the cleaning area R, and then the cleaning assembly 3 is switched to the first state; and when the detection structure 42 does not detect the wafer cassette 101, it indicates that the wafer cassette 101 is not in the cleaning area R, and then the cleaning assembly 3 is switched to the second state.

In the example of Fig. 8 to Fig. 10, the detection structure 42 is an infrared device and detects the wafer cassette 101 through an infrared signal, the detection structure 42 is disposed at a nozzle of the cleaning assembly 3, when the detection structure 42 detects the wafer cassette 101, it indicates that the wafer cassette 101 shields a detection signal of the detection structure 42, then the wafer cassette 101 is located on an ejection path of the cleaning assembly 3, so that at least part of the wafer cassette 101 is located in the cleaning area R; and when the detection structure 42 does not detect the wafer cassette 101, it indicates that the wafer cassette 101 does not shield the detection signal of the detection structure 42, then the wafer cassette 101 is not located on the ejection path of the cleaning assembly 3, so that the wafer cassette 101 is not located in the cleaning area R.

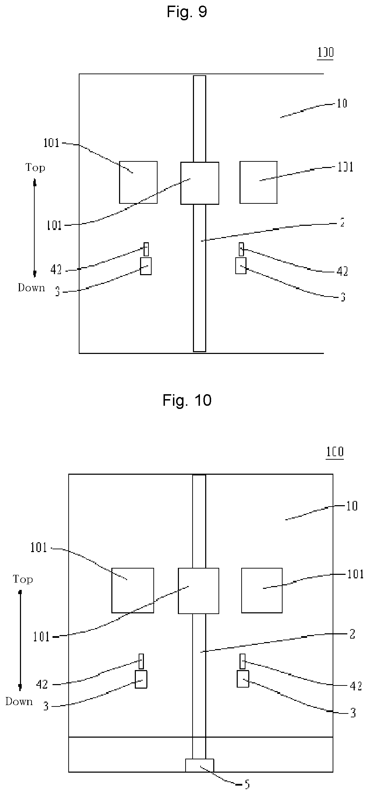

In some embodiments, as shown in Fig.7 and Fig. 10, the wafer cassette cleaning device 100 further includes a speed adjustment assembly 5, the speed adjustment assembly 5 is configured to adjust the rotating speed of the rotating frame 2, and when the cleaning assembly 3 is switched from the first state to the second state, the speed adjustment assembly 5 first increases the rotating speed of the rotating frame 2, and then reduces the rotating speed of the rotating frame 2, so that the rotating frame 2 quickly rotates to quickly pass through a "neutral period" in which the cleaning assembly 3 cannot effectively clean the wafer cassette 101, thereby effectively shortening the cleaning duration and improving the cleaning efficiency; and meanwhile, it is convenient to realize that the change in the rotating speed of the rotating frame 2 has good coherence in the whole cleaning process of the wafer cassette 101.

In some embodiments, the wafer cassette cleaning device 100 further includes a drying assembly, and the drying assembly is configured to dry the wafer cassette 101, so as to quickly dry the wafer cassette 101 after the wafer cassette 101 is cleaned.

In some embodiments, the drying assembly may include a gas drying structure and/or a heating structure, the gas drying structure may communicate with the cleaning chamber 10 through a nozzle, so as to ejection a dry gas, such as nitrogen, to the cleaning chamber 10, and the heating structure may be configured to heat the internal environment temperature of the cleaning chamber 10. For example, the heating structure may be an infrared heating lamp tube.

It can be understood that the setting position of the drying assembly may be set according to actual requirements, and it is only necessary to ensure that the drying assembly may dry the wafer cassette 101.

In some embodiments, the wafer cassette cleaning device 100 further includes an air filtering assembly and an exhaust assembly, and the air filtering assembly may filter and purify air and then send the air into the cleaning chamber 10, so as to maintain the internal environment of the cleaning chamber 10 during the operation of the wafer cassette cleaning device 100, thereby ensuring that the stability of the environment in the cleaning chamber 10; and the exhaust assembly may extract the air from the cleaning chamber 10, for example, in a drying process of the wafer cassette 101, the exhaust assembly extracts the moisture from the cleaning chamber 10, so as to improve the drying speed of the wafer cassette 101.

For example, the air filtering assembly may be an FFU.

Other compositions and operations of the wafer cassette cleaning device 100 according to the embodiments of the present disclosure are known to those ordinary skilled in the art, and thus are not described in detail herein.

In the description of the present disclosure, it should be understood that orientation or position relationships indicated by terms "center", "longitudinal", "transverse", "length", "width", "thickness", "upper", "lower", "front", "back", "left", "right", "vertical", "horizontal", "top", "bottom", "inside", "outside", "clockwise", "counterclockwise", "axial", "radial", "circumferential" and the like are generally orientation or position relationships shown on the basis of the drawings, and are merely for the convenience of describing the present disclosure and simplifying the description, but do not indicate or imply that the referred devices or elements must have specific orientations or must be constructed and operated in specific orientations, and thus cannot be construed as limitations to the present disclosure. In addition, the features defined with "first" and "second" may explicitly or implicitly include one or more of the features. In the description of the present disclosure, unless otherwise specified, the meaning of "a plurality of' is two or more.

In the description of the present disclosure, it should be noted that the terms "installed", "connected" and "connection" should be understood in a broad sense, unless otherwise expressly specified and limited. For example, the connection may be a fixed connection, and may also be a detachable connection, or an integral connection; may be a mechanical connection, and may also be an electrical connection; and may be a direct connection, may be an indirect connection through an intermediate medium, and may also be internal communication between two elements. For those ordinary skilled in the art, the specific meanings of the above terms in the present disclosure may be understood in specific situations.

In the description of the present specification, description with reference to the terms "one embodiment", "some embodiments", "illustrative embodiments", "examples", "specific examples" or "some examples" means that particular features, structures, materials or features, which are described in combination with the embodiments or examples, are included in at least one embodiment or example of the present disclosure. In the present specification, the schematic representation of the above terms does not necessarily refer to the same embodiment or example. Furthermore, the described particular features, structures, materials or features may be combined in any suitable manner in any one or more embodiments or examples.

Although the embodiments of the present disclosure have been shown and described, those ordinary skilled in the art may understand that various changes, modifications, substitutions and variations may be made to these embodiments without departing from the principles and purposes of the present disclosure, and the scope of the present disclosure is defined by the claims and the equivalents thereof.

## Claims

1. A method for controlling a wafer cassette cleaning device (100), wherein the wafer cassette cleaning device (100) is configured to clean a wafer cassette (101), and the wafer cassette cleaning device (100) comprises a cavity (1), a rotating frame (2) and a cleaning assembly (3), a cleaning chamber (10) is arranged in the cavity (1), the rotating frame (2) is rotatably disposed in the cleaning chamber (10) and is configured to fix the wafer cassette (101), the cleaning assembly (3) is disposed in the cavity (1), the cleaning assembly (3) has a cleaning area (R) and is configured to eject cleaning liquid to the cleaning area (R), the cleaning assembly (3) has a first state and a second state, and the amount of the cleaning liquid ejected by the cleaning assembly (3) in the first state is greater than the amount of the cleaning liquid ejected by the cleaning assembly (3) in the second state,
the method comprising:
the rotating frame (2) driving the wafer cassette (101) to rotate the wafer cassette (101) relative to the cleaning area (R);
judging whether the wafer cassette cleaning device (100) satisfies a preset condition, wherein the preset condition comprises that at least part of the wafer cassette (101) is arranged in the cleaning area (R); and
if it is judged that the wafer cassette cleaning device (100) satisfies the preset condition, switching the cleaning assembly (3) to the first state, and if it is judged that the wafer cassette cleaning device (100) does not satisfy the preset condition, switching the cleaning assembly (3) to the second state.

2. The method for controlling the wafer cassette cleaning device (100) according to claim 1, wherein,
the cleaning assembly (3) is open in the first state, and the cleaning assembly (3) is closed in the second state; or,
the cleaning assembly (3) is open in both the first state and the second state, and a liquid ejection pressure of the cleaning assembly (3) in the first state is greater than a liquid ejection pressure in the second state.

3. The method for controlling the wafer cassette cleaning device (100) according to claim 1 or 2, wherein the rotating frame (2) is adapted to mount N number of the wafer cassettes (101), N is larger than or equal to 1, and N is a positive integer,
when N is larger than or equal to 2, the N number of the wafer cassettes (101) are arranged at intervals along the circumferential direction of the rotating frame (2), and with an orthographic projection of a rotation axis of the rotating frame (2) as a circle center on a cross section of the rotating frame (2), a central angle corresponding to the cleaning area (R) is smaller than a central angle corresponding to an area between two adjacent wafer cassettes (101).

4. The method for controlling the wafer cassette cleaning device (100) according to claim 3, wherein the rotating frame (2) has a preset angle position, the wafer cassette cleaning device (100) comprises an angle detection structure (41), the angle detection structure (41) is configured to measure a rotation angle of the rotating frame (2),
when the rotating frame (2) rotates by a first angle from the preset angle position, it is judged that the wafer cassette cleaning device (100) does not satisfy the preset condition, when the rotating frame (2) continues to rotate by a second angle, it is judged that the wafer cassette cleaning device (100) satisfies the preset condition, until the rotating frame (2) continues to rotate by a third angle, it is judged that the wafer cassette cleaning device (100) does not satisfy the preset condition again,
wherein on the cross section of the rotating frame (2), with the orthographic projection of the rotation axis of the rotating frame (2) as the circle center, the sum of the second angle and the third angle is 360° /N.

5. The method for controlling the wafer cassette cleaning device (100) according to claim 3 or 4, wherein the wafer cassette cleaning device (100) comprises a detection structure (42), the detection structure (42) is configured to detect the wafer cassette (101), a detection direction of the detection structure (42) is the same as an ejection direction of the cleaning assembly (3),
when the detection structure (42) detects the wafer cassette (101), it is judged that the wafer cassette cleaning device (100) satisfies the preset condition, and when the detection structure (42) does not detect the wafer cassette (101), it is judged that the wafer cassette cleaning device (100) does not satisfy the preset condition.

6. The method for controlling the wafer cassette cleaning device (100) according to any one of claims 1-5, wherein the method further comprises:
when the cleaning assembly (3) is switched to the first state, the rotating frame (2) rotating at a rotating speed in a first rotating speed section, and when the cleaning assembly (3) is switched to the second state, the rotating frame (2) rotating at a rotating speed in a second rotating speed section, wherein the minimum rotating speed in the second rotating speed section is greater than the maximum rotating speed in the first rotating speed section.

7. The method for controlling the wafer cassette cleaning device (100) according to claim 8, wherein when the cleaning assembly (3) is switched to the first state, the rotating frame (2) rotates at a constant speed which is a first rotating speed, when the cleaning assembly (3) is switched to the second state, the rotating frame (2) first accelerates from the first rotating speed to a second rotating speed and then decelerates from the second rotating speed, and the rotating frame (2) decelerates to the first rotating speed until the cleaning assembly (3) is switched to the first state again.

8. A wafer cassette cleaning device (100), comprising:
a cavity (1), wherein a cleaning chamber (10) is arranged in the cavity (1);
a rotating frame (2), wherein the rotating frame (2) is rotatably disposed in the cleaning chamber (10) and is configured to fix a wafer cassette (101);
a cleaning assembly (3), wherein the cleaning assembly (3) is disposed in the cavity (1), the cleaning assembly (3) has a cleaning area (R) and is configured to ejection cleaning liquid to the cleaning area (R), the cleaning assembly (3) has a first state and a second state, and the amount of the cleaning liquid ejected by the cleaning assembly (3) in the first state is greater than the amount of the cleaning liquid ejected by the cleaning assembly (3) in the second state; and
an identification assembly (4), wherein the identification assembly (4) is configured to judge whether the wafer cassette cleaning device (100) satisfies a preset condition when the rotating frame (2) drives the wafer cassette (101) to rotate, when the identification assembly (4) judges that the wafer cassette cleaning device (100) satisfies the preset condition, the cleaning assembly (3) is switched to the first state, when the identification assembly (4) judges that the wafer cassette cleaning device (100) does not satisfy the preset condition, the cleaning assembly (3) is switched to the second state, and the preset condition comprises that at least part of the wafer cassette (101) is arranged in the cleaning area (R).

9. The wafer cassette cleaning device (100) according to claim 8, wherein,
the cleaning assembly (3) is open in the first state, and the cleaning assembly (3) is closed in the second state; or,
the cleaning assembly (3) is open in the first state and the second state, and a liquid ejection pressure of the cleaning assembly (3) in the first state is greater than a liquid ejection pressure in the second state.

10. The wafer cassette cleaning device (100) according to claim 8 or 9, wherein the rotating frame (2) is adapted to mount N number of the wafer cassettes (101), N is not less than 1, and N is a positive integer,
when N is larger than or equal to 2, the N number of the wafer cassettes (101) are arranged at intervals along the circumferential direction of the rotating frame (2), and with an orthographic projection of a rotation axis of the rotating frame (2) as a circle center on a cross section of the rotating frame (2), a central angle corresponding to the cleaning area (R) is smaller than a central angle corresponding to an area between two adjacent wafer cassettes (101),
the identification assembly (4) comprises an angle detection structure (41), and the angle detection structure (41) is configured to measure a rotation angle of the rotating frame (2)so as to judge whether the wafer cassette cleaning device (100) satisfies the preset condition or not, according to the rotation angle of the rotating frame (2); or,
the identification assembly (4) comprises a detection structure (42), a detection direction of the detection structure (42) is the same as an ejection direction of the cleaning assembly (3), and the detection structure (42) is configured to detect the wafer cassette (101), and judge whether the wafer cassette cleaning device (100) satisfies the preset condition according to whether the wafer cassette (101) is detected.

11. The wafer cassette cleaning device (100) according to any one of claims 8-10, further comprising:
a speed regulation assembly (5), configured to adjust a rotating speed of the rotating frame (2), wherein when the cleaning assembly (3) is switched from the first state to the second state, the speed adjustment assembly (5) is configured to increase the rotating speed of the rotating frame (2) firstly, and then reduce the rotating speed of the rotating frame (2).
